# EUROPEAN PATENT APPLICATION

(11) **EP 1 521 094 A1**
(43) Date of publication of application: **06.04.2005**
(21) Application number: 04256040.9
(22) Date of filing: 30.09.2004
(51) Int. Cl.: G01R 33/3415

(54) **Modular MR radio frequency coil array**

(30) Priority: 01.10.2003 US 677715
(71) Applicant: Gore Enterprise Holdings, Inc., Newark, DE 19714-9206 (US)
(72) Inventor: Williams, Neil R., Newark, DE 19711 (US); Levesque, Keith M., Oxford, PA 19363 (US); Martin, Richard D., Newark, DE 19711 (US)
(74) Representative: Shanks, Andrew

(57) **Abstract**

A modular MR coil array made of a plurality of circuits having a conductive trace mounted on a substrate, each of the circuits adapted to generate a signal; and means in each substrate for attaching and aligning at least two of the circuits to one another. Preferably the means for attaching and aligning the circuits are holes or openings formed in the substrates, designed to mate with corresponding holes or openings in the other substrates. In a preferred embodiment, the coil array also includes means disposed on each of the circuits for pre-amplifying the signal.

## Description

### Field of the Invention

The present invention relates to magnetic resonance (MR) imaging, and in particular to MR coil modules and a modular MR coil array produced therefrom.

### Background of the Invention

MR scanner systems are evolving in their capability to receive more and more information simultaneously from numerous surface coil arrays. That is, the receivers in the system were initially four, and now have grown to 8. This figure will continue to grow to 16 receivers and so on. These advances are due to new techniques in image acquisition known as parallel imaging.

Phased array coils and parallel imaging techniques have demonstrated shorter image acquisition times. By obtaining simultaneous independent views of the object being imaged, shorter acquisition times can be achieved by a factor of two or greater. This is possible by using information encoded in the spatial sensitivity patterns of an array coil. The increase in independent views acquired using additional independent transducer elements decreases acquisition times. Shorter acquisition times influences the amount of time a patient must spend in a MR scanner (patient scanner dwell time is shorter). In addition, shorter times yield greater quality images in motion sensitive applications (e.g., cardiac and breathing).

Therefore to harness the benefits of parallel imaging, more elements must be added to a surface coil array. Accordingly, there is a need for an increased number of receivers in a MR scanner to accommodate the individual elements. Also, along with the number of array elements, the configuration of the elements (determines sensitivity pattern) will also determine image acquisition time.

As the surface coil arrays start growing in the number of elements, ergonomic and electrical issues arise. These issues include more weight, crowding of element circuitry, more coil-related noise, increased signal losses. Even R&D and production time to build such arrays will be more significant compared to basic 4 or even 8 element arrays.

Current and future MR systems are being constructed without preamplifiers (preamps). The burden of preamplification is being passed onto surface coil arrays. Current MR preamplifiers are larger than one inch squared. The footprint that the preamp occupies limits where the device can be located. This is especially true with flexible surface coils. These types of coils are designed to be low profile and conformal when applied to patient imaging. For arrays with increasing numbers of receiving element transducers, there is relatively little or no room on the circuit board substrates for the preamps.

The next logical place to put the devices is in the connector house, which interface with the MR scanner. However, the cabling distance from the coil to the input of the preamp may be a foot to six feet or more. The extra loss incurred in the extra cable length lessens the amount of preamp decoupling that can be achieved. Preamp decoupling is a technique used to increase the signal to noise performance of a coil array. The extra loss in the cable minimizes the Q of the preamp decoupling resonant circuit. Additionally, as scanner field strengths increase, so will the transducer reception frequency. At higher fields, frequency dependent losses in the cable will increase, thus lowering Q, which in tern lowers preamp decoupling. Moreover, noise from each element collectively degrades the image. This is a significant problem, especially as the number of elements grows.

To address all of these longfelt needs in the industry, a system is needed that
- minimizes design and manufacturing time of the surface coil arrays,
- addresses real estate, performance and ergonomic concerns, and
- is capable of evolving in step with future MR scanning systems designed to harness parallel imaging techniques.

### Summary of the Invention

The present invention provides an MR coil array made of a plurality of circuits having a conductive trace mounted on a substrate, each of the circuits adapted to generate a signal; and means in each substrate for attaching and aligning at least two of the circuits to one another. Preferably the means for attaching and aligning the circuits are holes or openings formed in the substrates, designed to mate with corresponding holes or openings in the other substrates. In a preferred embodiment, the coil array also includes means disposed on each of the circuits for pre-amplifying the signal. The pre-amplifier includes matching circuitry to ensure low noise figure and high coil to coil isolation. The circuits are preferably flexible circuits, and the array in preferred embodiments has eight, sixteen, or thirty-two circuits. With the higher number of circuits (channels) the weight and loading of the coaxial interface becomes prohibitive. The circuit may include an analog to digital converter after the pre-amplifier to output a digital signal representation of the analog MR signal. One embodiment includes a fiber optic output to use light weight flexible optical fibers or photonic waveguides to interface from the coil array to the scanner. The circuit substrate is preferably polyimide or polytetrafluoroethylene (PTFE). The MR coil array can be designed to operate in systems generating field strengths from 0.2 Tesla to 8 Tesla. Optimization can be achieved for physiological as well as spectroscopy applications. The invention also provides that the circuits are modules that are interchangeable and adapted to overlap one another according to the requirements of a particular application, such that a modular MR coil array is formed. The circuits are either of the same size or different sizes, and of the same shape or different shapes from one another.

In another aspect, the present invention provides an MR coil module including a circuit having a conductive trace mounted on a substrate, the circuit adapted to generate a signal; and means in the substrate for attaching and aligning at least two of the circuit modules to one another to form a modular MR coil array.

In yet another aspect, the present invention provides a method of forming a modular MR coil array including the steps of providing a plurality of circuits having a conductive trace mounted on a substrate, each of the circuits adapted to generate a signal; providing means in each substrate for attaching and aligning at least two of the circuits; and attaching and aligning at least two of the circuits to one another to form a modular MR coil array.

### Brief Description of the Drawing

Fig. 1 is a plan view of an MR coil module according to an exemplary embodiment of the present invention.
Fig. 2 is a plan view of a modular MR coil array according to an exemplary embodiment of the present invention.
Fig. 3 is a plan view of a modular MR coil array according to another exemplary embodiment of the present invention.
Fig. 4A is a perspective view of a vertically stacked modular MR coil array according to another exemplary embodiment of the present invention.
Fig. 4B is a perspective view of a vertically stacked modular MR coil array according to another exemplary embodiment of the present invention.
Fig. 4C is a perspective view of a vertically stacked modular MR coil array according to another exemplary embodiment of the present invention.
Fig. 5 is a schematic view of a pre-amplifier according to an exemplary embodiment of the present invention.

### Detailed Description of the Invention

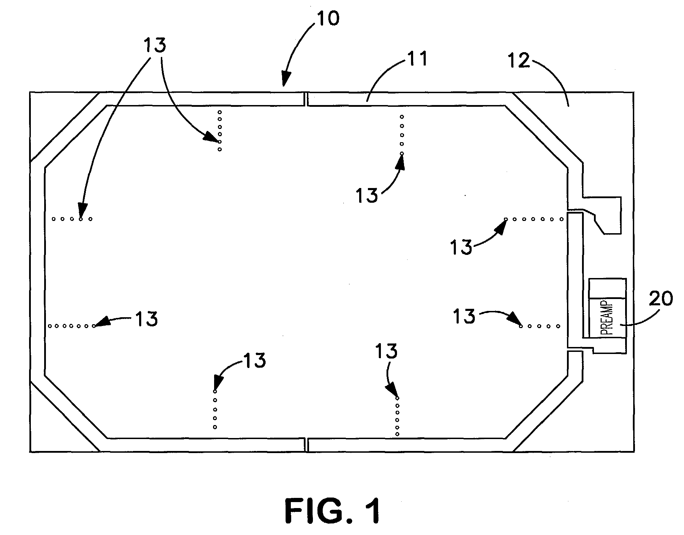

Fig. 1 illustrates an MR coil module 10 according to an exemplary embodiment of this invention. MR coil module 10 is a circuit having a conductive trace 11 mounted on a substrate 12. Preferably, the circuit is a flexible circuit (flex-circuit), and substrate 12 is a light flexible material that hosts functional electrical components such as conductive trace 11. Polyimide is preferred as a material for substrate 12, and polytetrafluoroethylene is an alternative material. Substrate 12,in conjunction with conductive trace 11 and associated pads and other electrical components can be constructed in large scale quantities at board processing houses. This feature reduces the assembly time compared to riveting together conductors to form conventional transducer arrays.

Substrate 12 is also provided with alignment holes 13. Alignment holes 13 are openings that mate with corresponding openings on other substrates. Alignment holes 13 are exemplary means for aligning substrates. Specifically, alignment holes 13 overlay those on adjoining modules, and can be attached using means for attaching the substrates such as pins, rivets, facets or other attachment devices disposed through the alignment holes 13. Substrates can be attached laterally, vertically or both. With this modularity capability, a variety of array designs can be fabricated. The array can be easily produced using manufacturing fixtures with pins that are strategically placed to guide the substrates 12 into specific locations in relation to each other. This is a fast and efficient way to manufacture arrays.

The modularity of the MR coil arrays disclosed herein provides distinct advantages. The MR surface coils can now be increased in step with scanner receiver number increases, and with evolving parallel imaging software designed to reduce scanning time. Using modules to build a surface coil array, expanding the number of coil elements to correspond to the number of scanner receivers is straightforward. Substrate modules are fabricated to incorporate more elements. Existing modules are removed and new modules installed. This increase in coil elements can occur in the lateral or vertical direction.

MR scanner software is becoming more sophisticated by using information derived from transducer element field patterns. Decreased scanning time is dependent on the number of elements and their geometries. The geometries will generate specific field patterns. So by adding transducer elements or manipulating geometrical configurations, scanning times can be reduced. As the scanning systems and software progress, the modules can be added to increase elements or replace existing geometries with geometries more suited for a specific application. The newly designed geometries can be added laterally or vertically. New modules can even overlay existing modules in the vertical direction to create a stacking of unique transducer configurations. This open architecture module system would allow faster conformability for these scanners by shortening R&D and production timelines.

Replacement of modules with overlays with more transducer elements or different transducer configurations is fast and efficient. Even smaller opportunities which may not have a large quantity of coil units may be realized due to short development and production times. Modules of different sizes and shapes can also be mixed and matched to come up with an optimum design within a very short time. Optimum module designs can be applied to physiological and spectroscopy based applications.

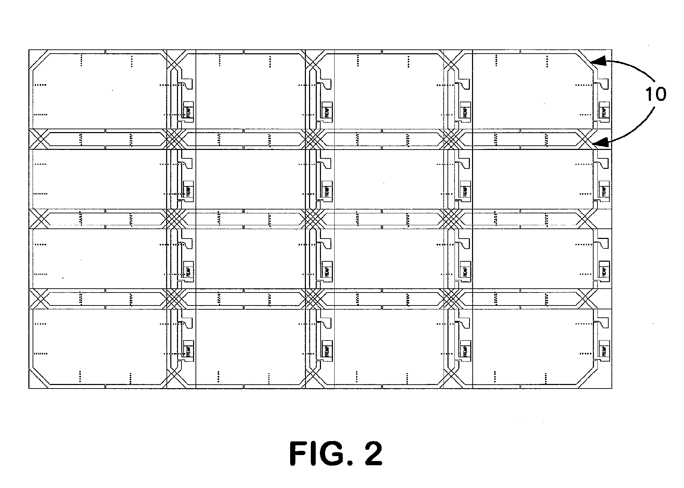

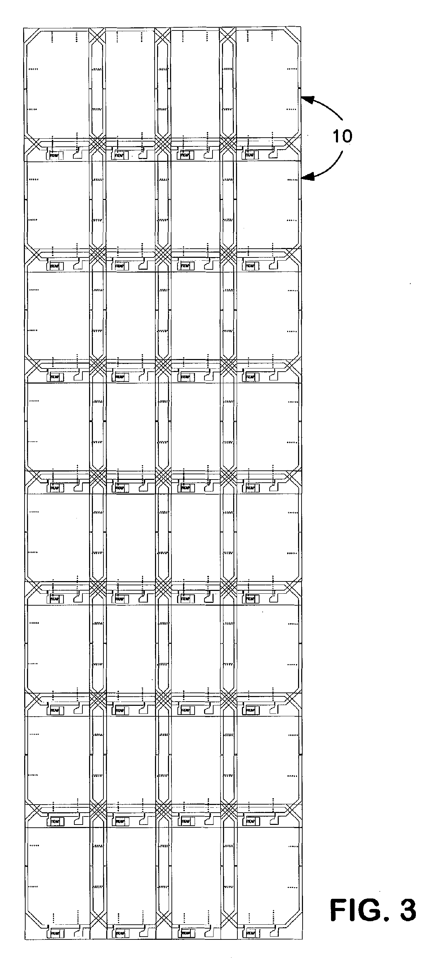

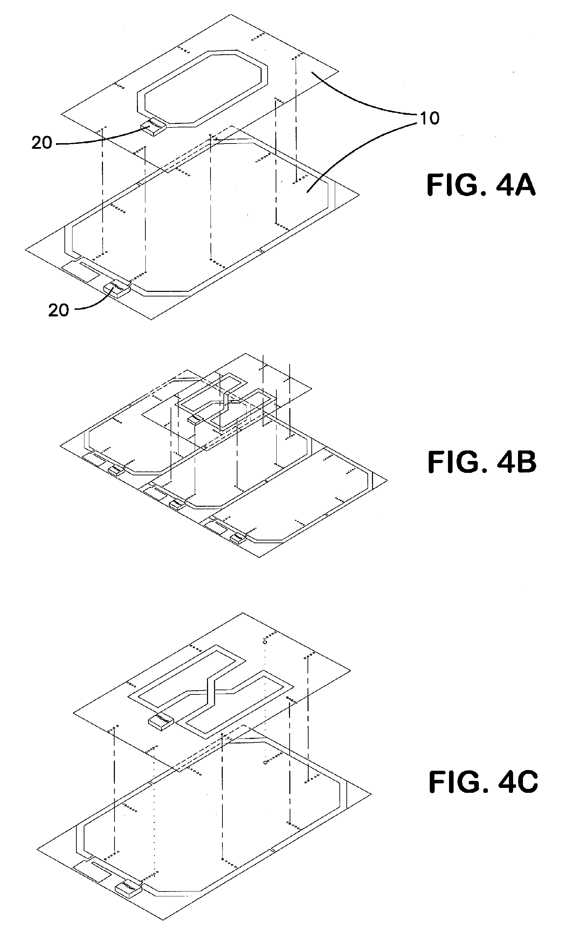

Fig. 2 illustrates a build-up in the lateral direction of up to sixteen coil modules 10. Fig. 3 illustrates a build-up of thirty-two coil modules 10. Fig. 4A shows a build-up in the vertical direction by using two modules which, in the illustrated embodiment, are of different sizes. This arrangement provides another degree of freedom in optimizing the array for parallel imaging and thus reduce imaging acquisition time. Fig. 4B is another embodiment of a vertically stacked arroay in which the top coil is of both different size and shape from the bottom coils. Fig. 4C is an illustration of yet another embodiment of a vertically stacked array. Using the present invention, any number of coils may be stacked as required by a particular application.

Referring back to Fig. 1, coil module 10 is also provided with preamplifer 20 mounted on substrate 12. Associated connection circuitry (not shown) added to the substrate creates an electronically independent module capable of receiving and "handing off' signal information. The preamplifiers 20 can be surface mounted at a board manufacturing facility, thus eliminating substrate population times during array production.

To satisfy real estate as well as electrical performance requirements, preamplifier 12 is miniaturized to a fraction of the size of current offerings. This allows placement right next to or on the transducer element, economizing space and weight. Existing MR preamplifiers are enclosed in a metal can to shield internal preamp circuitry. The extra metal adds weight and volume area. By scaling down the size of preamplifier 12, metal shielding is scaled down as well. This is quite meaningful when there could be as many as sixty-four or more preamplifiers inside the coil array. With preamplifier 12 attached directly to the transducer, electrical losses are reduced and preamp decoupling is maximized.

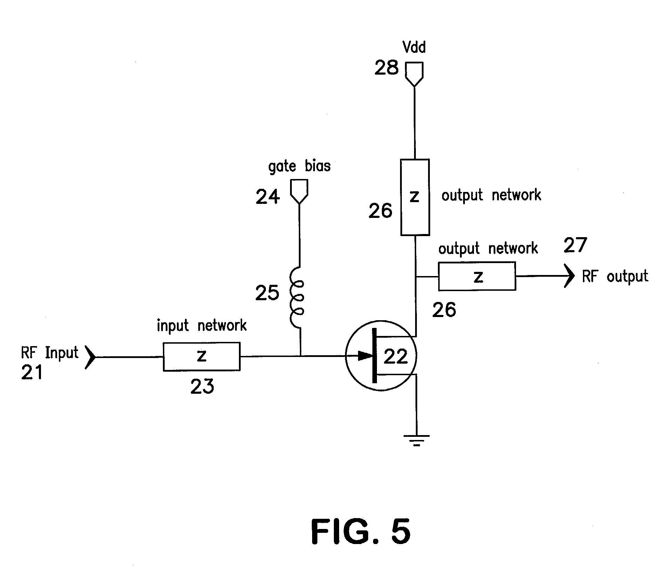

With specific reference to Fig. 5, a miniaturized pre-amp according to the present invention is constructed as follows. A Radio Frequency (RF) signal a surface coil 21 is coupled to a very low noise Gallium Arsenide (GaAs) Field Effect Transistor (FET) 22 (available from Agilent Technologies, part number ATF-531P8) with an input matching network 23 optimized for low Noise Figure (NF) and optimal isolation of the MR coil. An inductor 25 was used to provide the proper gate bias 24 to FET 22, along with an active bias current mirror. An output network 26 optimized for NF was used to provide the proper Drain to Source Voltage (Vdd) 28 to FET 22 as well as provide a 50-ohm output for the amplifier RF signal 27.

The present invention thus provides a self-contained receiving system or module, which consists of an E&M transducer, miniaturized preamplifier, and associated circuitry. All electrical components including the transducer are attached to a light flexible substrate. The substrate includes of registration or alignment holes on the periphery of the substrate, which would overly and connect with the borders of other similar modules. This attachment can be done laterally, vertically or both.

This invention provides an MR coil system that minimizes design and manufacturing time of the surface coil arrays; addresses real estate, performance and ergonomic concerns; and provides flexibility to evolve in step with future MR scanning systems. These are all long-felt needs in the industry for which no adequate solution has been provided before the present invention.

While particular embodiments of the present invention have been described herein, the present invention is not intended to be limited to such descriptions. It should be apparent that changes and modifications may be incorporated and embodied as part of the present invention within the scope of the following claims.

## Claims

1. An MR coil array comprising:
(a) a plurality of circuits having a conductive trace mounted on a substrate, each of said circuits adapted to generate a signal; and
(b) means in each said substrate for attaching and aligning at least two of said circuits to one another.

2. An MR coil array as defined in claim 1 further comprising means disposed on each of said circuits for pre-amplifying said signal.

3. An MR coil array as defined in claim 1 or 2 wherein said circuits are flexible circuits.

4. An MR coil array as defined in claim 1, 2 or 3 comprising eight of said circuits.

5. An MR coil array as defined in claim 1, 2 or 3 comprising sixteen of said circuits.

6. An MR coil array as defined in claim 1, 2 or 3 comprising thirty-two of said circuits.

7. An MR coil array as defined in any of claims 1 to 6 wherein said substrate comprises polyimide.

8. An MR coil array as defined in any of claims 1 to 7 wherein said substrate comprises PTFE.

9. An MR coil array as defined in any of claims 1 to 8 adapted to operate at field strengths from 0.2 Tesla to 8 Tesla.

10. An MR coil array as defined in any of claims 1 to 9 wherein at least two of said circuits overlap one another.

11. An MR coil array as defined in any of claims 1 to 10 wherein at least two of said circuits are interchangeable.

12. An MR coil array as defined in any of claims 1 to 11 wherein at least two of said circuits are different sizes.

13. An MR coil array as defined in any of claims 1 to 12 wherein at least two of said circuits are different shapes.

14. An MR coil array as defined in any of claims 1 to 13 wherein said means for attaching and aligning at least two of said circuits to one another comprises a plurality of openings formed in said substrates of said circuits.

15. An MR coil array as defined in any of claims 1 to 14 further comprising means disposed on each of said circuits for pre-amplifying said signal and wherein said means for pre-amplifying comprises matching circuitry.

16. An MR coil array as defined in any of claims 1 to 15 further comprising means disposed on each of said circuits for pre-amplifying said signal and further comprising a fiber optic interface at an output of said means for pre-amplifying.

17. An MR coil array as defined in any of claims 1 to 16 further comprising means disposed on each of said circuits for pre-amplifying said signal and wherein said means for pre-amplifying is adapted to output digital signals.

18. An MR coil array as defined in any of claims 1 to 17 further comprising means disposed on each of said circuits for pre-amplifying said signal and wherein said means for pre-amplifying is adapted to output analog signals.

19. An MR coil array as defined in any of claims 1 to 18 further comprising means disposed on each of said circuits for pre-amplifying said signal and wherein said means for pre-amplifying is adapted to output both analog and digital signals.

20. An MR coil array comprising:
(a) at least eight flexible circuits having a conductive trace mounted on a substrate, each of said flexible circuits adapted to generate a signal;
(b) means in each said substrate for attaching and aligning said flexible circuits to one another; and
(c) means disposed on each of said flexible circuits for pre-amplifying said signal.

21. An MR coil module comprising:
(a) a circuit having a conductive trace mounted on a substrate, said circuit adapted to generate a signal; and
(b) means in said substrate for attaching and aligning at least two of said circuit modules to one another to form a modular MR coil array.

22. A method of forming a modular MR coil array comprising the steps of:
(a) providing a plurality of circuits having a conductive trace mounted on a substrate, each of said circuits adapted to generate a signal;
(b) providing means in each said substrate for attaching and aligning at least two of said circuits; and
(c) attaching and aligning at least two of said circuits to one another to form a modular MR coil array.
